# EUROPEAN PATENT SPECIFICATION

(11) **EP 1 146 596 B1**
(45) Date of publication and mention of the grant of the patent: **28.12.2005**
(21) Application number: 00122279.3
(22) Date of filing: 19.10.2000
(51) Int. Cl.: H01R 12/22, H01R 4/02, H01R 12/32, H01R 43/02, H05K 3/34

(54) **Method of mounting an electrical connector to a substrate**
Montageverfahren eines elektrischen Verbinders auf einem Substrat
Méthode pour monter un connecteur électrique sur un support

(30) Priority: 19.10.1999 US 160482 P
(43) Date of publication of application: 17.10.2001
(73) Proprietor: FCI, 78000 Versailles (FR)
(72) Inventor: Olson, Stanley W., East Berlin, Pennsylvania 17316 (US); Shuey, Joseph B., Camp Hill, Pennsylvania 17011 (US)
(74) Representative: Beetz & Partner

(56) References cited:
- EP-A- 0 789 422
- WO-A-97/43885
- WO-A-97/44859
- US-A- 4 217 024
- US-A- 5 743 009
- US-A- 5 810 607
- US-A- 5 919 050

## Description

The invention relates to a method of mounting an electrical connector to a substrate according to the preamble portion of patent claim 1. Such a method is known from US-A-4 217 024.

Various types of electrical connectors rely upon surface mount technology (SMT) to secure the connector's contacts to an underlying substrate SMT connectors provide numerous benefits over earlier connectors, such as simplified manufacturing and lower costs.

While providing such advantages, the use of SMT may raise other issues. One concern, for example, involves the ability of the solder joint between the contact and the underlying substrate to absorb forces caused by, for example, shipping, handling, mating and thermal cycling. Should one solder joint become unusable as a result of damage from any of these events, the entire connector adversely may be affected.

Ball grid array (BGA) technology is one type of SMT. Generally speaking, an electrical connector using a BGA has a housing with a contact therein. A fusible element, typically a solder ball, secures to each contact. The solder balls serve as the primary connection between the contact and the surface of the substrate. A reflow process fuses the solder ball to the substrate. During the reflow process, a beneficial "self-centering" feature of BGA technology occurs. Specifically, as the solder reflows, the surface tension of the solder helps to align the connector properly with the conductive pads on the underlying substrate.

As with SMT connectors, forces on the solder joint in a BGA connector also poses a concern. Because of the self-centering ability of BGA connectors, however, many of the solutions used in SMT connectors cannot be used on BGA connectors.

Therefore, a need exists to develop techniques for providing strain relief to BGA connectors.

US-A-4 217 024 discloses a method of mounting an electrical connector to a substrate comprising providing an electrical connector having a contact and a hold down, providing a substrate and securing said contact to said substrate.

The hold downs of this connector are secured on said substrate before the contacts, This does not allow the contacts to selfadjust their final position before solidification of the solder.

This object is accomplished with a method as claimed. Dependent claims are directed on features of preferred embodiments of the invention.

### Brief description of the drawings

Other uses and advantages of the invention will become apparent to those skilled in the art upon reference to the specification and the drawings, in which:
- Figure 1: is an exploded, top perspective view of an electrical connector the method according to the present invention is applied to;
- Figure 2A: is a bottom, perspective view of the electrical connector in Figure 1;
- Figure 2B: is a bottom, perspective view of an alternative embodiment of the electrical connector in Figure 1;
- Figure 3: is a partial cut-away view of the electrical connector in Figure 1;
- Figure 4: is a top perspective view of a second alternative embodiment of a connector the method according to the invention is applied to.
- Figure 5: is a bottom view of the electrical connector in Figure 4;
- Figure 6A: is a bottom perspective view of a third alternative embodiment of a connector the method according to the present invention is applied to;
- Figure 6B: is a partial cut-away view of the electrical connector in Figure 6;
- Figure 7: is a perspective view of an electrical connector modified to ensure that the connector remains substantially parallel to the substrate during a reflow process, according to the invention; and
- Figures 8A-8B: show a portion of a substrate so as to illustrate the self-centering characteristics according to the present invention.

### Detailed Description of the Method according to the Invention

Each of the alternative connectors described herein is a surface mounted electrical connector having strain relief features. Preferably, fusible elements, such as solder balls, secure the contacts to conductive elements on the substrate using ball grid array (BGA) technology. Because BGA connectors tend to precisely align relative to the conductive pads on the substrate during reflow (known as the "self-centering"), the strain relief features discussed herein preferably do not interfere with this desirable characteristic. An intrusive reflow is preferably used to secure the strain relief to the substrate. "Intrusive" refers to the placement of fusible material (e.g., solder paste) within an opening in the substrate (e.g., plated through hole). Each alternative connector will now be described in more detail below.

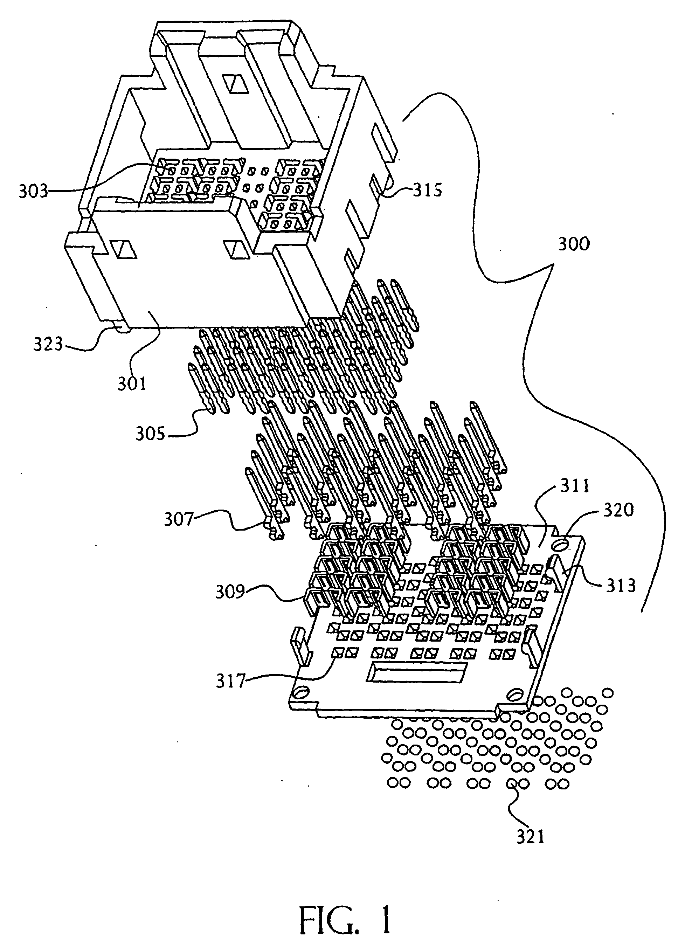

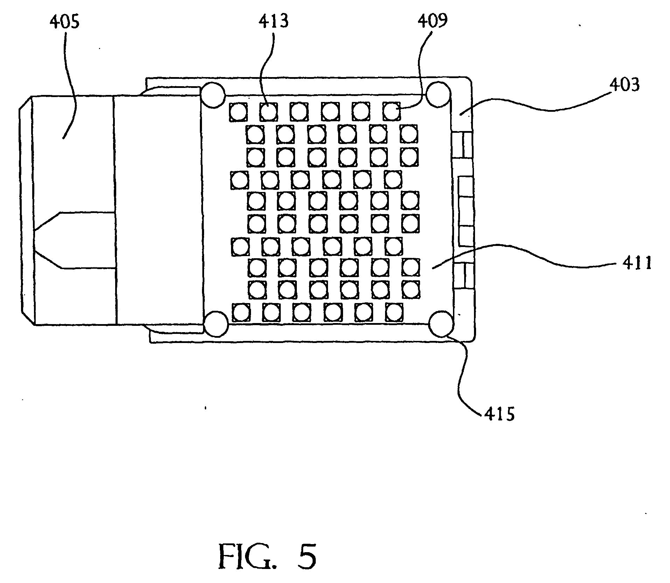

Figures 1-3 display electrical connector 300. Connector 300 is a backplane header connector that preferably mates with a backplane receptacle connector (as shown in Figure 5). Connector 300 can be used in a backplane system, for example, to connect a daughtercard to a motherboard.

Connector 300 uses many of the features described in U.S. Patent Application serial number 09/302,027. Accordingly, only a brief discussion of certain features of connector 300 is necessary for an understanding of the invention.

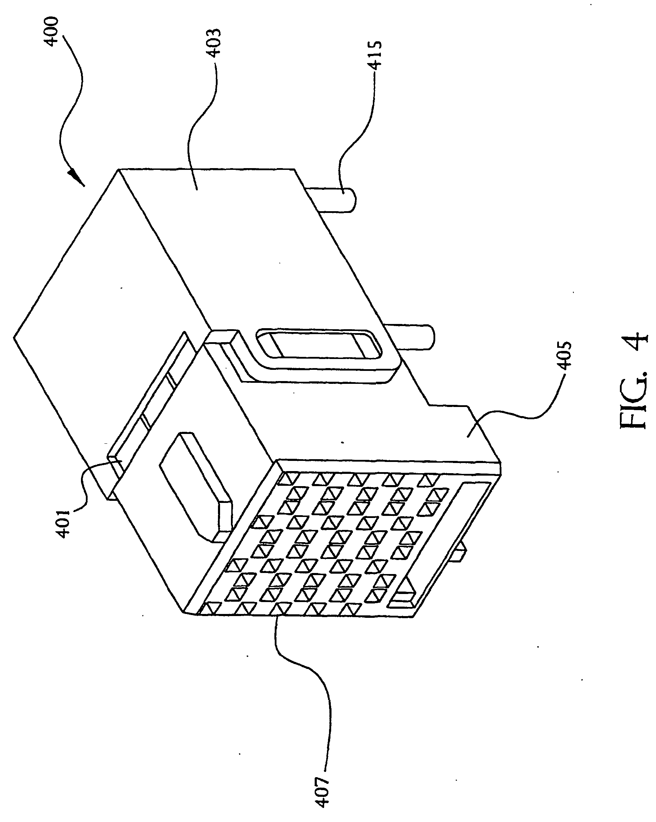

Connector 300 includes an insulative housing 301 with apertures 303 therethrough that accept signal contacts 305, ground contacts 307 and ground shields 309. The mating ends of signal contacts 305 and ground contacts 307 extend through housing 301 and correspond to the arrangement of lead-in apertures in a mating connector (as shown in Figure 4). Ground shields 309 preferably remain within housing 301, engage ground contacts 307 and act to surround signal contacts 305 in a differential pairing arrangement.

Connector 300 surface mounts to a substrate 325, preferably using the BGA technology discussed in International Publication number WO 98/15991. This aspect of the invention differs from the through hole mounting of the contacts described in U.S. Patent Application serial number 09/302,027.

In one possible manner of surface mounting, connector 300 could use a wafer 311 that latches to housing 301. Wafer 311 could have latch arms 313 that engage suitable latch structure 315 on housing 301. In addition, wafer 311 has apertures 317 therethrough corresponding to the locations of contacts 305, 307. Specifically, the distal ends of contacts 305, 307 extend through apertures 317. The distal ends of contacts 305, 307 preferably reside within apertures 317, but could extend beyond apertures 317.

In a manner similar to that described in International Publication number WO 98/15991, pockets on the bottom surface of wafer 311 can receive solder paste (not shown) provided during a squeegee operation. Thereafter, the pockets now filled with solder paste can receive, and temporarily retain, a fusible element 321. A reflow operation then fuses solder balls 321 to contacts 305, 307. Any other manner of securing fusible elements 319 to contacts 305, 307 could be used, however.

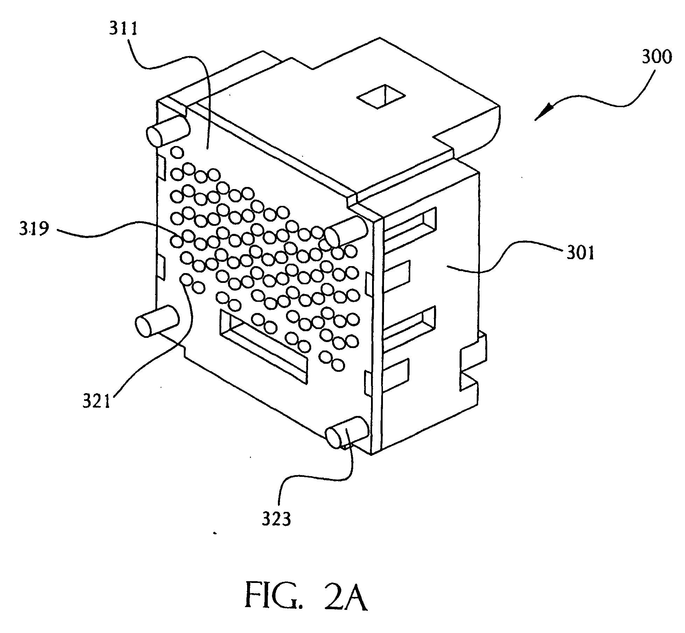

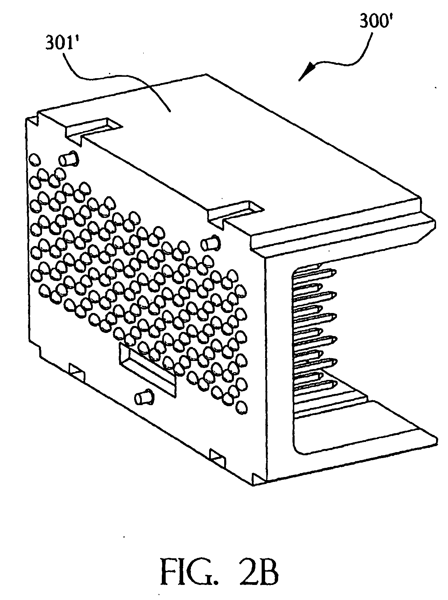

Figure 2B provides an alternative embodiment of connector 300. As shown in Figure 2B, housing 301' of connector 300' is a single continuous structure. This is to be distinguished from connector 300, as shown in Figure 2A, where wafer 311 is shown as a separate portion of housing 301.

Connector 300 can mount to substrate 325 having an array of conductive pads 327 connected to suitable traces (not shown) to transmit signals or for grounding purposes, for example. Pads 327 correspond to the array of fusible elements 321 secured to contacts 305, 307 on connector 300. As an alternative, pads 327 could also be vias.

A reflow process, typically subsequent to the reflow process that fused solder balls 321 to contacts 305, 307, fuses solder balls 321 to pads 327. Typically, the pads have solder paste 326 thereon to accept and to temporarily secure solder balls 321 to substrate 325. As described earlier, a squeegee drawn across a stencil (not shown) placed on the substrate provides suitable amounts of solder paste at desired locations. The reflow process fuses solder ball 321 to pad 327 on substrate 325, thus creating an electrical path between contacts 305, 307 and substrate 325.

Due to the mechanical loading requirements and durability requirement of backplane connectors, connector 300 may require strain relief features to protect the solder joints formed by solder balls 321: Connector 300 may use intrusively reflowed hold-downs. Housing 301 includes posts 323 adjacent to the four corners, or at any other suitable location.

When assembled, posts 323 extend past wafer 311 and reside within through holes 328 in substrate 325. Preferably, posts 323 are made from a suitable solderable material, such as a metal or a metallized plastic. Significantly, the diameter of post 323 is smaller than the diameter of plated through hole 328 that receives post 323. Stated differently, posts 323 are generally unrestrained within through holes 328 before the reflow step.

This allows solder balls 321 to self-center upon reflow without interference. Despite the ability of posts 323 to move within through holes 328, posts 323 do, however, provide rough alignment and guidance when placing connector 300 on substrate 325.

The reflow process used to secure solder balls 321 to substrate 325 preferably also secures posts 323 to through hole 328 in substrate 325. As with conductive pads 327, through holes 328 receive solder paste 329 during the squeegee operation. The reflow process fuses posts 323 to substrate 325.

Posts 323 serve as the strain relief for connector 300. Despite being an intrusive hold-down, posts 323 allow solder balls 321 to self-center during reflow. Prior to the reflow process, posts 323 extend into solder paste-filled through holes 328, while solder balls 321 rest upon solder paste 326 on conductive pads 327. During the heating stage of the reflow process, solder paste 326 tends to liquefy before solder balls 321.

While liquid, solder balls 321 will self-center relative to conductive pads 327 on substrate 325. Posts 323, being smaller than through holes 328, allows movement of connector 300 without interference.

At the end of the reflow process, posts 323 tend to cool more slowly than solder balls 321. As a result, the solder in this area stays liquid longer. This allows the benefit of an intrusive hold-down, while retaining the self-centering characteristic of solder balls 321.

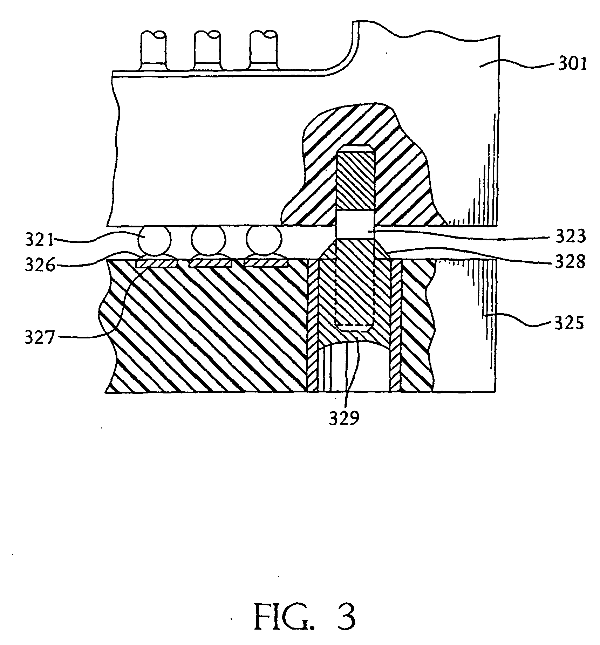

Figure 3 is a partial cut-away view of connector 300 providing greater detail of the construction and application of post 323. As shown in Figure 3, post 323 is fixedly attached to connector 300, such as by placing a knurled section of post 323 into an opening in housing 301 after stenciling the solder paste. As connector 301 is placed upon substrate 325, post 323 passes into through hole 328 in substrate 325. Also, solder balls 321 align with conductive traces 327 on substrate 325. Solder balls 321 rest on solder paste 326 placed on conductive traces 327. Similarly, post 323 resides within solder paste 329 located in through hole 328. As the connector system is heated, solder balls 321 liquefy and electrically couple to conductive pads 327, and post 323 attaches to the interior of through hole 328.

The system also may be designed such that post 323 secures to through hole 328 after solder balls 321 fuses to conductive pads 327. In this way, post 323 also will provide strain relief to the connector system without inhibiting the self-centering characteristics of the BGA connector. The diameters of post 323 and through hole 328 are sized and toleranced so as to reduce any interference with the self-centering action of the BGA attachment techniques, while also ensuring that solder balls 321 initially engage at least a portion of solder pad 327. Also, the protrusion of post 323 into through hole 328 is such that optimum fillets will be formed inside and above through hole 328 without restricting the self-centering action. Post 323 is sized such that a significant amount of solder paste 329 will not be forced out of through hole 328 during the mounting process. For example, Figure 3 shows that post 323 extends approximately halfway into through hole 328.

Figures 4 and 5 display electrical connector 400. Receptacle backplane connector 400 uses many of the features described in U.S. Patent No. 6,116,926, herein incorporated by reference. Because a detailed discussion of many of the features of connector 400 are unnecessary for an understanding of the invention, only a brief summary of these features follows.

Connector 400 is modular, formed by a series of sub-assemblies 401. Rear insulative housing 403 and front insulate housing 405 can latch together and surround sub-assemblies 401 to form connector 400. Front housing 405 includes lead-in openings 407 that accept conductive contacts 305, 307 from mating connector 300 (as shown in Figure 1). As shown, openings 407 form a differential pair arrangement.

Sub-assemblies 401 contain the ground and signal contacts (not shown). The ground and signal contacts mate with corresponding ground contacts 307 and signal contacts 305 of mating connector 300 (as shown in Figure 1). Differently than shown in U.S. Patent No. 6,116,926, the contacts of connector 400 surface mount to a substrate (not shown).

In one possible manner of surface mounting, connector 400 could use a wafer 411 that latches to housing 401. Wafer 411 could have latch arms (not shown) that engage suitable latch structure (not shown) on housing 401. In addition, wafer 411 has apertures 413 therethrough corresponding to the locations of the contacts. Specifically, the distal ends of the contacts extend through apertures 413. The distal ends of the contacts preferably reside within apertures 413, but could extend beyond apertures 413.

In a manner similar to that described in International Publication number WO 98/15991, apertures 413 can receive solder paste (not shown) provided during a squeegee operation. Thereafter, apertures 413, now filled with solder paste, can receive and temporarily retain a fusible element 409. A reflow operation then fuses solder balls 409 to the contacts. Any other manner of securing fusible elements 409 to the contacts could be used, however.

As with the earlier described conectors, connector 400 can mount to a substrate (not shown) having an array of conductive pads (not shown) connected to suitable traces (not shown) to transmit signals or for grounding purposes, for example. The pads correspond to the array of fusible elements 409 secured to the contacts on connector 400. As an alternative, the pads could also be vias.

A reflow process, typically subsequent to the reflow process that fused solder balls 409 to the contacts, fuses solder balls 409 to the pads. Typically, the pads have solder paste (not shown) thereon to accept and to temporarily secure solder balls 409 to the substrate. As described earlier, a squeegee drawn across a stencil (not shown) placed on the substrate provides suitable amounts of solder paste at desired locations. The reflow process fuses solder ball 409 to the pad on the substrate, thus creating an electrical path between the contacts and the substrate.

As with connector 300, connector 400 may require strain relief features to protect the solder joints formed between the contacts and the pads on the substrate. As with connector 300, connector 400 utilizes intrusive, solderable hold-downs. Housing 401 can include posts 415 adjacent the four corners, or any other suitable location. When assembled, posts 415 extend past wafer 411 and reside within through holes (not shown) in the substrate. Preferably, posts 415 are made from a suitable solderable material such as metal or metallized plastic. Significantly, the diameter of posts 415 is smaller than the diameter of the through hole. Stated differently, posts 415 generally are unrestrained within the through holes prior to reflow. As discussed below, this allows solder balls 409 to self-center upon reflow without interference. Despite the ability of posts 415 to move within the through holes, posts 415 do, however, provide rough alignment and guidance when placing connector 400 on the substrate. In fact, posts 415 and PCB through holes are sized to ensure that solder balls 409 initially engage at least a portion of the solder pad.

The reflow process used to secure solder balls 409 to the substrate preferably also secures posts 415 to the through hole in the substrate. As with the conductive pads, the through holes receive solder paste during the squeegee operation. The reflow process fuses posts 415 to the substrate.

Posts 415 serve as the strain relief for connector 400. Despite being an intrusive hold-down, posts 415 allow solder balls 409 to self-center during reflow. Prior to the reflow process, posts 415 extend into solder paste-filled through holes, while solder balls 409 rest upon solder paste on the conductive pads. During the heating stage of the reflow process, the solder paste tends to liquefy before solder balls 409.

While liquid, solder balls 409 will self-center relative to the conductive pads on the substrate. Posts 415, being smaller than the through holes, allows movement of connector 400 without interference.

At the end of the reflow process, posts 415 tend to cool more slowly solder balls 409. As a result, the solder in this area stays liquid longer. This allows the benefit of an intrusive hold-down, while retaining the self-centering characteristic of solder balls 409.

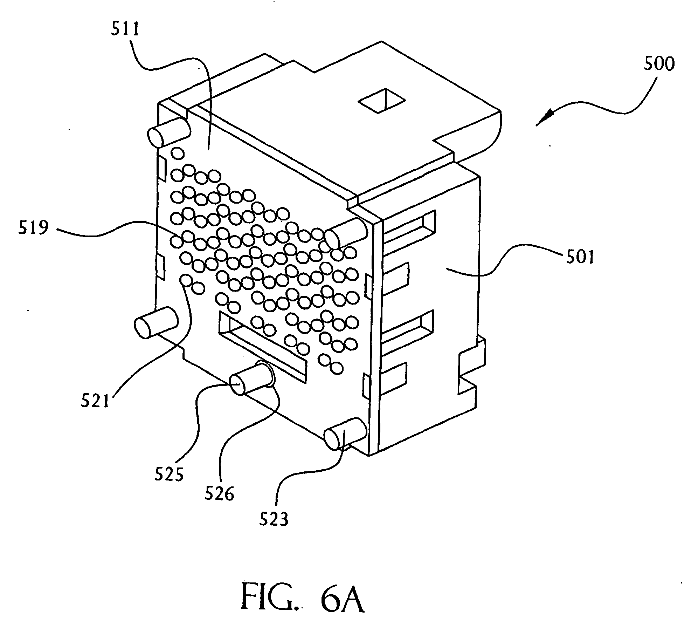

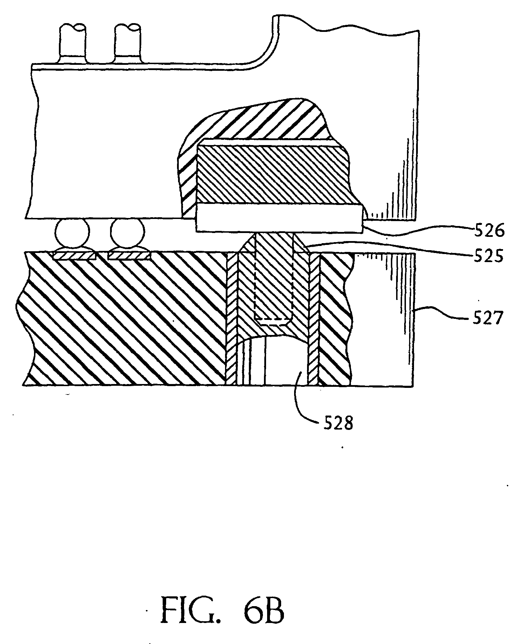

Figures 6A and 6B display electrical connector 500. In particular, Figure 6A provides a bottom perspective view of electrical connector 500, and Figure 6B provides a partial cut-away view of the connector. Connector 500, while generally similar to connector 300, is preferably used in situations, for example, where the weight of connector 500 may flatten solder balls 521 and cause bridging between adjacent solder balls 521.

Accordingly, housing 501 of connector 500 can include a retention post 525 in addition to, or as a substitute for, posts 523. Differently than posts 523, post 525 has a shoulder 526 that cannot enter plated through hole 528. Shoulder 526 keeps connector 500 from substrate 527 when solder balls 521 liquefy to prevent bridging. In other words, a suitable post 525 acts as a standoff and prevents solder balls 521 from being flattened by the weight of the connector 500. As with posts 523, post 525 can be made from a solderable material. Preferably, shoulder 526 allows some flattening of the ball (e.g., up to approximately 40 percent and preferably approximately 30 percent) to ensure a proper solder joint with PCB pad. Shoulder 526 also can prevent skewing of connector 500 on substrate 527, caused, for example, by a connector that is not uniformly balanced. The distal end of post 525 can enter plated through hole 528 and serve as a hold-down.

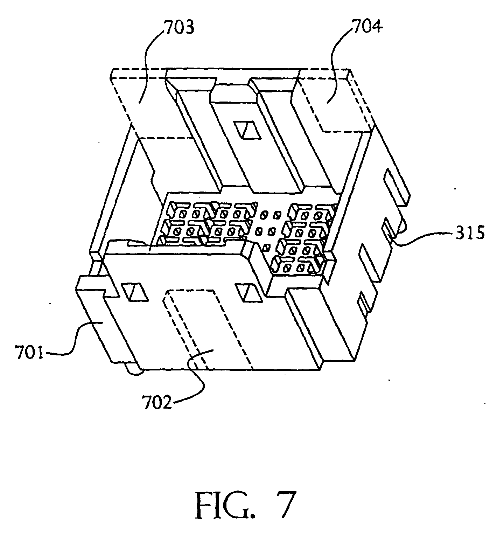

Figure 7 is another example of how the invention ensures that the BGA connector remains substantially parallel to the substrate during reflow. As discussed with reference to connectors 300, 400 and 500, the BGA connector is attached to the substrate by heating the solder balls until the solder melts and becomes fused to the conductive traces of the substrate. The surface tension of the solder centers the connector on the traces of the substrate. In situations where the connector design requires an arrangement where the weight of the connector is not uniformly balanced, the connector may become skewed with respect to the substrate during the reflow process. During reflow, a heavier portion of the connector could "flatten" the solder balls thereunder more so than the lighter portion.

As a result, certain of the solder balls may not make proper contact with the substrate, possibly causing the solder joint to fail under a less than nominal mechanical force. Also, adjacent collapsed solder balls could bridge. The invention ensures that the BGA connector remains substantially parallel to the substrate during reflow.

As shown in Figure 7, portions of connector 701 (shown dashed for purposes of clarity) may be added and/or removed to allow the mass of connector 701 to be evenly balanced over the ball grid array. In particular, a portion 702 may be removed from a heavier section of housing 701. Portions 703 and 704 may be added to lighter sections of housing 701. Although Figure 7 shows portions 702-704 in certain locations, it should be appreciated that the location, as well as the size and weight of portions 702-704 will vary depending upon the physical characteristics of connector 701.

Although Figure 7 illustrates balancing connector 701 on the substrate by modifying the physical characteristics of the connector, it should be appreciated that the invention is not so limited. The invention may accomplish such balancing using a number of techniques. For example, an external force may be applied to certain areas of connector 701 during the reflow process. The magnitude of such a force would be determined so as to overcome the skewed relation of connector 701 and the substrate, caused by the imbalance of the connector over the ball grid array. In another embodiment, a similar force may be applied to the substrate, in addition to or instead of the connector. Therefore, the invention includes any technique that overcomes the inherent imbalance of the connector over its ball grid array, and allows the connector to be substantially parallel with the attached substrate after reflow.

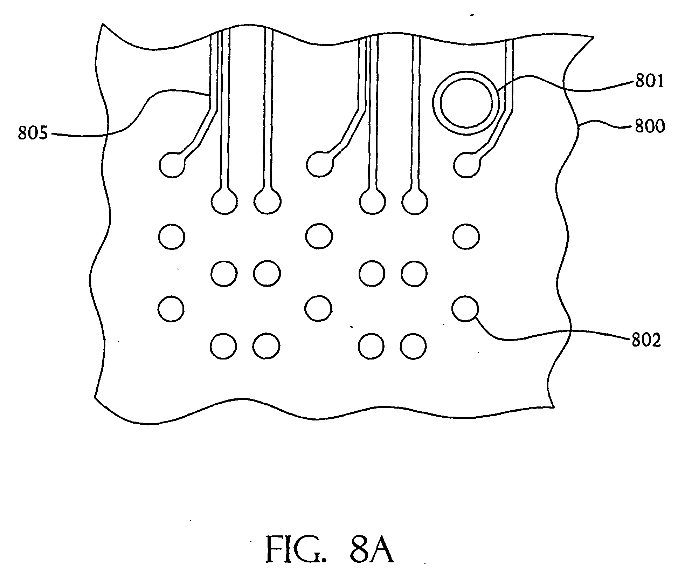

Figures 8A-8C show a portion of a substrate 800, and illustrate the self-centering characteristics of the inventive connector during the reflow process. First, Figure 8A shows substrate 800 without a connector soldered thereto. Substrate 800 includes plated through hole 801, solder pads 802; and conductive traces 805 (shown, for clarity, as only extending from certain pads 802). Solder pad 802 is adapted to receive a fusible element on a connector (e.g., as shown in Figure 3), and conductive path 805 carries a signal along substrate 800. Through hole 801 is adapted to receive a hold-down on the connector.

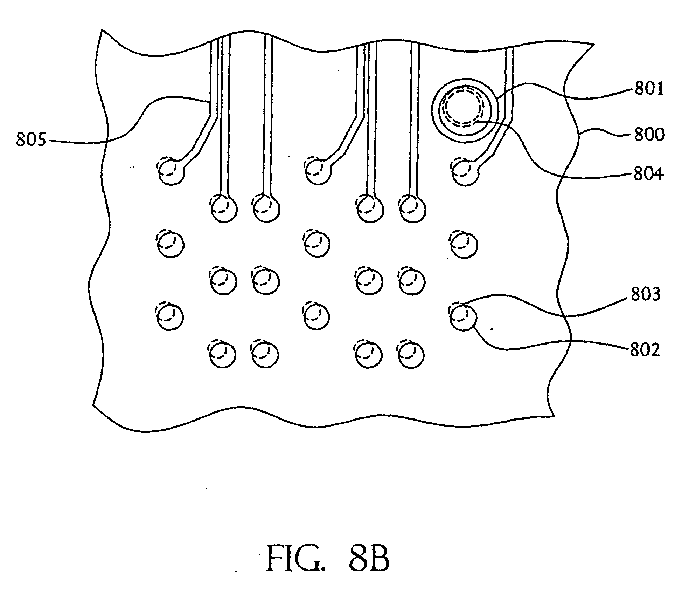

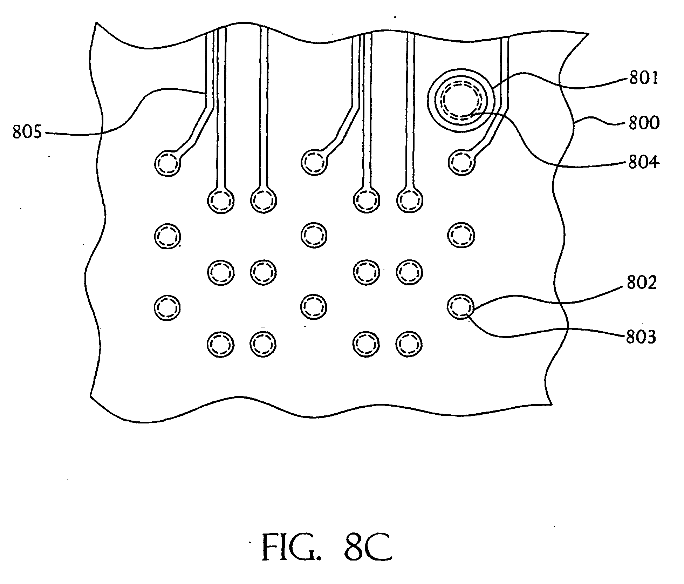

Figure 8B illustrates the next step in the process, namely the positioning of the connector with solder balls 803 and hold-downs 804 (shown dashed for clarity) on top of substrate 800. As shown in Figure 8B, connector is positioned in a worst-case scenario with respect to substrate 800, such that solder balls 803 and hold-downs 804 are furthest from the center of solder pads 802 and through hole 801, respectively. Figure 8C illustrates the next step in the process, namely the reflow of solder balls 803 and the solder paste in the through holes that receive and hold-downs 804. As shown in Figure 8C, although solder balls 803 and hold-downs 804 initially were positioned in a worst case scenario (as shown in Figure 8B),the self-centering characteristic of the connector, moves solder balls 803 and hold-downs 804 such that they are centered over solder pads 802 and within through hole 801, respectively. Therefore, regardless of the initial positioning of the connector over substrate 800, the self-centering characteristics of the reflow process permit solder balls 802 and hold-downs 804 to center over solder pads 802 and within through hole 801, respectively.

While the invention has been described in connection with the preferred embodiments of the various figures; it is to be understood that other similar embodiments may be used or modifications and additions may be made to the described embodiment for performing the same function of the invention without deviating therefrom. Therefore, the invention should not be limited to any single embodiment, but rather construed in breadth and scope in accordance with the recitation of the appended claims.

## Claims

1. A method of mounting an electrical connector (300; 400; 500) to a substrate, comprising:
providing an electrical connector (300; 400; 500) having a contact (307) and a hold down (323);
providing a substrate (325);
securing said contact (307) to said substrate (325);
**characterized by**
placing said hold down (323) into said substrate (325); and
securing said hold down (323) to said substrate (325), wherein said securing comprises soldering said hold down (323) to said substrate, wherein said securing said contact (307) occurs before said securing said hold down (323).

2. The method as recited in claim 1,
**characterized by**
further comprising constructing said electrical connector such that it remains substantially parallel when mounted to said substrate (325).

3. The method as recited in claim 1,
**characterized by**
further comprising balancing said electrical connector on said substrate such that said electrical connector remains substantially parallel to said substrate (325) during said securing.

4. The method as recited in claim 1,
**characterized in that** said electrical connector is a ball grid array connector.

## Patentansprüche

1. Montageverfahren eines elektrischen Verbinders (300; 400; 500) auf einem Substrat, mit folgenden Schritten:
Bereitstellen eines elektrischen Verbinders (300; 400; 500) mit einem Kontakt (307) und einem Niederhalter (323);
Vorsehen eines Substrates (325); und
Befestigen des Kontaktes (307) am Substrat (325);
**gekennzeichnet durch**
Plazieren des Niederhalters (323) im Substrat (325); und
Befestigen des Niederhalters (323) am Substrat (325), wobei das Befestigen das Anlöten des Niederhalters (323) am Substrat beinhaltet, wobei das Befestigen des Kontakts (307) vor dem Befestigen des Niederhalters (323) erfolgt.

2. Verfahren nach Anspruch 1,
**gekennzeichnet durch**
den elektrischen Verbinder derart zur konstruieren, dass er im Wesentlichen parallel zum Substrat bleibt, wenn er auf diesem montiert wird.

3. Verfahren nach Anspruch 1,
**gekennzeichnet durch**
Ausbalancieren des elektrischen Verbinders auf dem Substrat derart, dass der elektrische Verbinder während seiner Befestigung im Wesentlichen parallel zum Substrat (325) bleibt.

4. Verfahren nach Anspruch 1,
**dadurch gekennzeichnet, dass** der elektrische Verbinder ein Kugelgittermatrixverbinder ist.

## Revendications

1. Une méthode pour monter un connecteur électrique (300, 400, 500) sur un support, comprenant :
la fourniture d'un connecteur électrique (300, 400, 500) possédant un contact (307) et un élément de retenue (323) ;
la fourniture d'un support (325) ;
la fixation dudit contact (307) sur ledit support (325) ;
**caractérisée par**
le placement dudit élément de retenue (323) dans ledit support (325) ; et
la fixation dudit élément de retenue (323) audit support (325), dans lequel la fixation comprend le soudage dudit élément de retenue (323) sur ledit support, dans lequel ladite fixation dudit contact (307) se produit avant ladite fixation dudit élément de retenue (323).

2. La méthode selon la revendication 1,
**caractérisée en ce qu'**
elle comprend en outre la construction dudit connecteur électrique de sorte qu'il reste en grande partie parallèle une fois monté sur ledit support (325).

3. La méthode selon la revendication 1,
**caractérisée en ce qu'**
elle comprend en outre l'équilibrage dudit connecteur électrique sur ledit support de sorte que ledit connecteur électrique reste en grande partie parallèle audit support (325) durant ladite fixation.

4. La méthode selon la revendication 1,
**caractérisée en ce que**
ledit connecteur électrique est un connecteur à réseau de grille à bille (BGA).
